(19) Europäisches Patentamt
European Patent Office
Office européen des brevets

(11) Publication number: **0 165 507**
**A2**

(12) # EUROPEAN PATENT APPLICATION

(21) Application number: 85106490.7

(22) Date of filing: 25.05.85

(51) Int. Cl.⁴: C 08 L 85/02
H 01 L 21/312, H 01 L 21/225

(30) Priority: 18.06.84 US 621752

(43) Date of publication of application:
27.12.85 Bulletin 85/52

(84) Designated Contracting States:
DE FR GB IT

(71) Applicant: ALLIED CORPORATION
Columbia Road and Park Avenue P.O. Box 2245R (Law Dept.)
Morristown New Jersey 07960(US)

(72) Inventor: Anello, Louis Gene c/o Allied Corporation
P.O. Box 2245R
Morristown, NJ 07960(US)

(72) Inventor: Kirtley, Stephen Wakefield c/o Allied Corporation
P.O. Box 2245R
Morristown, NJ 07960(US)

(72) Inventor: Harnish, Daniel Franklin c/o Allied Corporation
P.O. Box 2245R
Morristown, NJ 07960(US)

(74) Representative: Baillie, Iain Cameron et al,
c/o Langner Parry Isartorplatz 5
D-8000 München 2(DE)

(54) **Phosphoric triamides and polymers thereof as dopants.**

(57) Phosphorus triamides or their polymers are described as phosphorus dopants adapted to be spun-on to a semiconductor substrate and used in integrated circuit manufacture. Sheet resistivities of 4 to 13 ohms per square are obtained at low weight loadings in 1 hour, 1000°C diffusions.

The polymer (or monomers), are homogeneous and soluble and are easily distributed uniformly on the semiconductor surface, such as by the spin-on method; are relatively non-volatile so that when the solvent is removed and the material heated to diffusion temperatures, the desired film will be substantially intact; and are capable of being rendered insoluble, i.e. crosslinked thermally or otherwise, and are characterized as glassy rather than crystalline.

The polymeric solution may be employed in the manufacture of semiconductor components and, as such, the solution may be spun-on silicon wafers to function as a phosphorus impurity source (dopant) in thermal diffusions. Such doped wafers are then used in integrated circuit manufacture.

EP 0 165 507 A2

## DESCRIPTION

## PHOSPHORIC TRIAMIDES AND POLYMERS THEREOF AS DOPANTS

This invention relates to the use of phosphoric triamides as phosphorus dopants for use in semiconductor manufacture and more particularly to dopant compositions adapted to be spun on to a semiconductor substrate and used in integrated circuit manufacture. The dopant is comprised of a polymer (or monomer), at least a substantial part of the backbone of which contains phosphorus-nitrogen phosphoric triamide units, in the form of a glassy resin dissolved in an organic solvent.

## BACKGROUND OF THE INVENTION

The use of various compositions as a source of phosphorus impurity atoms for solid state diffusions in the fabrication of semiconductor devices has been known for many years. In theory, the dopant source provides improved control over dopant concentration and more uniform distribution of dopant concentrations. As a practical matter, however, these advantages have not been generally achieved heretofore to the desired practical level by the industry. This is perhaps due to insufficient need in the past or due to the non-availability of suitable performing dopants.

The concept of providing a stable liquid suspension or solution of phosphorus doped oxide, or a solution of ingredients which yield a phosphorus doped oxide film, has been considered. However, commercial use of such techniques has been impeded by practical difficulties in formulating a suspension or solution which is sufficiently stable and pure, and which can be formulated with practical reproducibility.

A dopant material to be useful, practical and perform satisfactorily must be homogeneous and soluble so that it is easily distributed uniformly on the semiconductor surface, such as by the spin-on method; it must be relatively non-volatile so that when the solvent is

removed and the material heated to diffusion temperature, the desired film will be substantially intact; it must be capable of being rendered insoluble; i.e., crosslinked thermally or otherwise and preferably characterized as glassy rather than crystalline. Accordingly, a need exists for such an economical and easily applied spin-on phosphorus dopant system.

SUMMARY OF THE INVENTION

The phosphorus-nitrogen dopants employed in the invention are derived from the class of materials known as phosphoric triamides or their polymers of the formula

$$(R\ NH)_3\ P{:}X \text{ and } \left[ -\overset{\overset{\displaystyle X}{\|}}{\underset{\underset{\displaystyle R}{|}}{\underset{NH}{\underset{|}{P}}}} - \underset{\underset{\displaystyle R}{|}}{N} - \right]_n$$

where R is selected from the group consisting of H, aliphatic, cyclic and aromatic type radicals, and X is selected from the group consisting of oxygen and sulfur and at least one R group is always either an aliphatic, cyclic or aromatic type radical and wherein n has a value of at least 2 and an upper value limited only by the requirement that the polymer be soluble under the conditions of use. Illustrative examples of nitrogen substituted phosphorus and thio phosphorus triamides are: $PO(NHC_2H_5)_3$, $Pr^nNHPO(NH_2)_2$, $PO(NHC_6H_{11})_3$, $PO(NH\text{-}t\text{-}C_4H_9)_3$, $PO(NHPr^n)_3$, $PS(NHPr^i)_3$, $C_6H_{11}\text{-}NHPO(NH_2)_2$, $PO(NHC_4H_9)_3$, $PO(NHC_6H_5)_3$, $PS(NHC_6H_{11})_3$ wherein the symbols $Pr^n$ and $Pr^i$ designated n-propyl and isopropyl, respectively and "t" designates "tertiary." The polymers of the triamides are prepared by heating the triamides to temperatures of 150° to 300°C for a period of about one hour to about eight hours with the elimination of volatiles. The reaction is illustrated by the following equation:

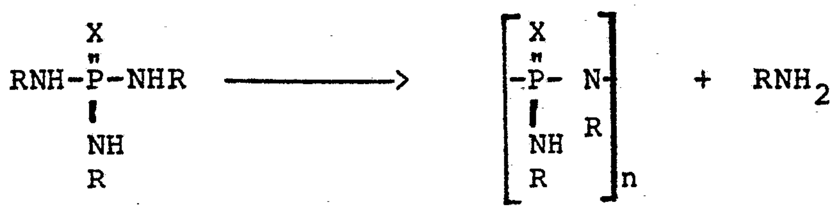

wherein "R" and "n" leave the values defined above. The nature of the polymer depends upon the maximum reaction temperature. Cyclic dimers such as

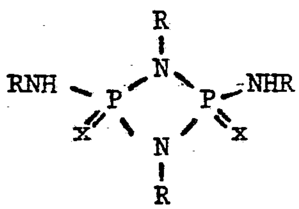

or cyclic trimers such as

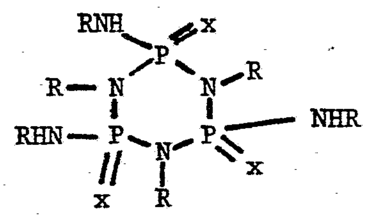

may be formed at the lower reaction temperatures with the linear polymer formed at the higher temperatures.

The formation of dimers and polymers of this kind is know and is disclosed in the prior art, for example, in U.S. Patent 2,666,750 and U.S. Patent 3,516,965 and in J.D. Healy et al. Phosphorus and Sulfur 5 239 (1978) and H. Bock et al. Chem. Ber. 99 377 (1966). The preparation of phosphoric trimides is also known and is disclosed for example, by L.F. Audrieth et al. J.A.C.S. 64 1553 (1942); R.R. Holmes et al. Inorg. Chem. 1 89 (1962), Inorg. Chem. 2 380 (1963); L. Bub et al. German Patent 1,005,963; and in U.S. Patent 3,433,623. However, the preparations and use of suitable dopant compositions from the described triamides and related polymers is not known.

It is the object of the invention to provide novel polymeric (or monomeric) phosphoric triamide spin-on phosphorus dopants that offer significant advantages.

More particularly, the invention provides phosphorus-nitrogen species for semiconductor dopant compositions that as diffusion sources, are not sensitive to moisture and afford processing latitude and are not prone to create damage to and/or staining of the silicon crystal substrate structure on which the dopant composition is applied. Other objects and advantages will be apparent from the description herein set forth.

## DESCRIPTION OF THE PREFERRED EMBODIMENTS

In preparing the dopant composition in accordance with the invention the phosphoric triamide monomers or polymers are dissolved in suitable organic solvent, such as chloroform, toluene, ethanol, or 1,2-dichloroethane and the like, at a 1 to 20% (wt/wt) level and spun onto silicon wafers to function as phosphorus impurity sources (dopant) in thermal diffusions. The doped wafers thus prepared are then used in integrated circuit manufacture.

It is important that the polymer (or monomer) employed in accordance with the invention be homogeneous and soluble, so that it is easily distributed uniformly on the semiconductor surface, such as by the spin-on method, and be relatively non-volatile so that when the solvent is removed and the material heated to diffusion temperatures, the desired film will be substantially intact, and capable of being rendered insoluble, i.e. crosslinked thermally or otherwise, and preferably, characterized as glassy rather than crystalline.

The invention provides a phosphorus-nitrogen species for semiconductor dopant compositions that as a diffusion source, is not sensitive to moisture and affords processing latitude and is not prone to create damage to and/or staining of the silicon crystal structure substrate.

The phosphorus-nitrogen compounds used in preparing the dopants in accordance with the invention are derived from the class of materials known as phosphoric triamides or from the polymers of phosphoric triamides and

have the formula

$(R\ NH)_3P{:}X$ and 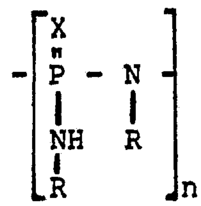

where R is selected from the group consisting of H, aliphatic, cyclic and aromatic radicals, X is selected from the group consisting of oxygen or sulfur and at least one R group is always an aliphatic, cyclic or aromatic radical, and "n" has a value of from 2 to about 500. Illustrative examples of nitrogen substituted phosphorus and thio phosphorus triamides of this kind are: $PO(NHC_2H_5)_3$, $PO(NHC_6H_{11})_3$, $PO(NHt\text{-}C_4H_9)_3$, $Pr^nNHPO(NH_2)_2$, $PO(NHPr^n)_3$, $PS(NHPr^i)_3$, $PO(NHC_4H_9)_3$ $PO(NHC_6H_5)_3$, $C_6H_{11}NHPO(NH_2)_2$, $PS(NHC_6H_{11})_3$.

The polymers of the triamides may be prepared by heating the triamides to temperatures of the order of 150° to 300°C for a period of about one hour to about eight hours with the elimination of volatiles. The polymerization is illustrated by the linear polymers of the following equation:

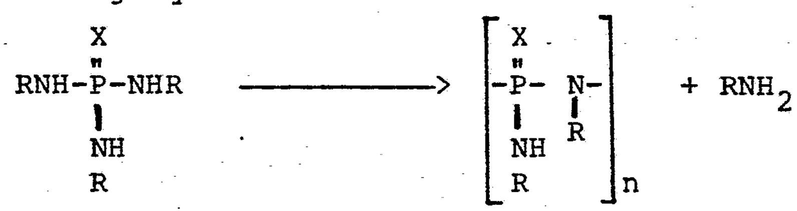

The nature of the polymer depends upon the maximum reaction temperature and reaction duration.

The polymers of the invention include also polymers of this kind which contain a small amount i.e., at least 0.1 and preferably at least 0.5 weight percent of cyclic units selected from the group consisting of cyclic dimers of the formula

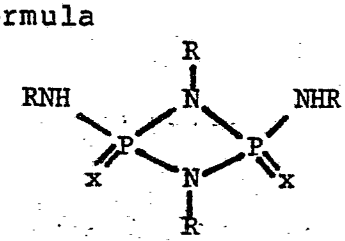

and cyclic trimers of the formula

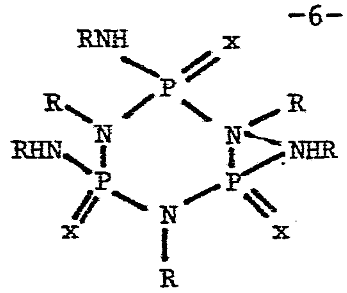

wherein R has the value given above, excluding, however, hydrogen. These polymers may be formed at the lower reaction temperatures with the linear polymer formed at the higher temperatures.

The invention will be further described by the following specific examples in which phosphoric triamide compositions capable of yielding polymers that may be rendered glassy and insoluble and used as dopants are prepared. It will be understood that the details provided in the examples are given primarily for purpose of illustration and should not be construed as a limitation of the invention. Proportions expressed are parts by weight unless otherwise specified.

EXAMPLE I

Preparation of Phosphoric Tri-N-Cyclohexylamide

Forty-eight grams (0.31 mole) of $POCl_3$ was slowly added to 220 g (2.22 moles) of cyclohexylamine dissolved in 250 ml benzene. After initial reaction, the mixture was refluxed for 4 hours at 80°C. The amine-hydrochloride was removed by filtration and washed with 100 ml of benzene. Upon removal of the solvent from the combined filtrates, a residue was obtained which solidified into a brown mass upon standing. A small portion of the solid, after washing with water to remove traces of amine hydrochloride, was recrystallized from petroleum ether to give a product of m.p. 246-250°C.

EXAMPLE II

Preparation of Phosphoric Tri-N-t-butylamide

Sixty-two grams (0.40 mole) of $POCl_3$ was slowly added to 210 g (2.86 moles) of tertiary butylamine dissolved in 300 ml of petroleum ether. After initial reaction, the mixture was refluxed for 2 hours at

30°C. The amine-hydrochloride was removed by filtration and the residue, after removal of solvent, was washed with water to remove residual amine-hydrochloride. After drying, a white crystalline product of m.p. 246-247°C was obtained.

EXAMPLE III

Preparation of Phosphoric Tri-N-Piperidide

Sixty-nine grams (0.45 mole) of $POCl_3$ was added to 24.4 g (2.86 moles) of piperidine dissolved in 300 ml of hexane at 0°C over a 1 hour period. The mixture was stirred to reflux of 65°C for 1 hour, cooled and filtered to remove amine-hydrochloride. After evaporation of solvent, a tan solid of m.p. 42-45°C was obtained.

EXAMPLE IV

Preparation of Thiophosphoric Tri-N-cyclohexylamide

Forty-one grams (0.24 mole) of $PSCl_3$ was added to 170 g (1.72 moles) of cyclohexylamine dissolved in 300 ml hexane at 0°C over a one hour period. After addition was complete, the mixture was heated to reflux for a 2 hour period. The amine-hydrochloride was removed by filtration and the filtrate evaporated to dryness under vacuum to remove hexane solvent. A waxy brown solid of m.p. 140-145°C was recovered.

EXAMPLE V

Preparation of Phenyl Phosphoric Di-N-Cyclohexylamide

Fifty-eight grams (0.30 mole) of phenyl phosphoric dichloride was slowly added to 132.5 g (1.31 moles) of cyclohexylamine dissolved in 300 ml benzene at 25°C over a one hour period. The mixture was then heated to reflux for 3 hours. The amine-hydrochloride was removed by filtration and the filtrate evaporated under vacuum to give a waxy brown product. The solid was recrystallized from hexane to give a white crystalline product of m.p. 145-152°C.

EXAMPLE VI

Pyrolysis of Phosphoric Tri-N-Cyclohexylamide

A sample of the waxy product from Example I $[PO(NHC_6H_{11})_3]$ was heated in a nitrogen atmosphere to

230-235°C for a 3 hour period. Traces of cyclohexylamine condensate were evolved and the recovered resin was waxy in nature. Similarly a fresh sample of $PO(NHC_6H_{11})_3]$ was heated to 280°C for a half hour where upon 3.9 g of cyclohexylamine condensate was obtained and the resin was a lustrous brown solid. Both resins were soluble in ethanol, chloroform and toluene.

EXAMPLE VII

Preparation of Phosphorus N-t-butylimide

Sixty-two grams (0.46 mole) of $PCl_3$ was slowly added to 235 g (3.20 moles) of t-butyl amine dissolved in 300 ml of hexane at 0°C over one hour period. The mixture was then heated to reflux for 2 hours and the amine-hydrochloride removed by filtration. After removal of the solvent from the filtrate a tan solid was recovered which on recrystallization had a m.p. of 138-142°C.

EXAMPLE VIII

Preparation of Phosphoric Tri-N-Propylamide

Seventy-eight grams (0.51 mole) of $POCl_3$ was slowly added to 197 g (3.32 moles) of propylamine dissolved in 300 ml of methylene chloride at 0°C over a one hour period with stirring. The mixture was then heated to 35°C for 2 hours and the amine-hydrochloride precipitate removed by filtration. After removal of the solvent, there was recovered 160 g of crude product, which was dissolved in benzene, refiltered and the filtrate evaporated to dryness under vacuum. There was recovered 139 g of triamide product which had a m.p. of 60-61°C.

EXAMPLE IX

Preparation of Phosphoric Tri-N-Isopropylamide

Seventy-eight grams (0.51 mole) of $POCl_3$ was slowly added to 197 g (3.32 moles) of isopropylamine dissolved in 300 ml of benzene at 0°C over a one hour period. After heating to 35°C for 2 hours the mixture was filtered and the filtrate evaporated to yield 144 g of desired triamide product.

EXAMPLE X

Preparation of Phosphoric Tri-N-Butylamide

Sixty-six grams (0.43 mole) of $POCl_3$ was slowly added to 209 g (2.06 moles) of n-butylamine dissolved in 300 ml of benzene at 0°C over a one hour period. After heating to 50°C for 2 hours the mixture was filtered and the filtrate evaporated to yield 107 g of desired triamide product which had a m.p. of 65-68°C.

EXAMPLE XI

Pyrolysis of Phosphoric Tri-N-Propylamide

A 56.1 (0.254 mole) sample of triamide $PO(NHPr^n)_3$, from Example VIII was heated in a nitrogen atmosphere at 250°C for 4-1/4 hours. About 20 g of a liquid condensate which was made up of a mixture of propyl, dipropyl and tripropyl amines was recovered along with 34 g of a yellowish brittle solid in the flask. The polymeric solid was soluble in methanol, methylene chloride and chloroform.

EXAMPLE XII

Pyrolysis of Phosphoric Tri-N-Isopropylamide

A 50.7 g (0.23 mole) sample of the triamide, $PO[NHCH(CH_3)_2]_3$, from Example IX was heated to 250-260°C for 1-3/4 hours. About 20.5 g of a liquid condensate was recovered along with 27.3 g of a reddish brittle solid in the flask. The polymeric solid was soluble in methanol.

EXAMPLE XIII

Pyrolysis of Phosphoric Tri-N-Butylamide

A 36 g (0.14 mole) sample of the triamide $(PO(NHBu^n)_3$, from Example X was heated to 250°-270°C for 3-3/4 hours. About 13 g of liquid condensate was recovered along with 20 g of a light tan brittle solid in the flask. The polymeric solid was soluble in methanol.

EXAMPLE XIV

Preparation of Propylamine N-phosphoric diamide $Pr^nNHPO(NH_2)_2$

Seventy seven grams (0.44 mole) of $Pr^nNHPOCl_2$ along with 35 g (0.23 mole) of $POCl_3$ impurity was dissolved

into 200 ml benzene. After the mixture was cooled to -5°C, anhydrous ammonia was passed into the stirred solution until excess ammonia appeared in a -78°C cooled trap. The temperature was raised to 30°C and the solution gassed with ammonia for 2 hours to ensure completion of the reaction. The formed amine -HCl and $NH_4Cl$ salts were removed by filtration and the filtrate evaporated to dryness, whereupon about 35 g (0.25 mole) of desired $Pr^nNHPO(NH_2)_2$ was obtained in 56.5% yield

EXAMPLE XV

Pyrolysis of $Pr^nNHPO(NH_2)_2$

A 35 g sample of the triamide $Pr^nNHPO(NH_2)_2$ from the above example was heated in a nitrogen atmosphere to 195-258°C for 1 hour. About 30 g of a dark brittle solid was recovered in the flask. The polymeric solid was soluble in methanol.

EXAMPLE XVI

Preparation of Cyclohexylamine N-phosphoric diamide

Two hundred eighteen grams (1.0 mole) of $C_6H_{11}NHPOCl_2$ was dissolved in 300 ml methylene chloride. The mixture was cooled to +5°C and gassed with anhydrous ammonia over 1 hour. The temperature was raised and the solution gassed with ammonia over a 2 hour period to ensure completion. The formed amine-HCl and $NH_4Cl$ salts were removed by filtration and the filtrate evaporated to dryness, whereupon 55 g (0.32 mole) of desired $C_6H_{11}NHPO(NH_2)_2$ was obtained in 32% yield.

EXAMPLE XVII

Pyrolysis of Cyclohexylamine N-phosphoric diamide

Example (RDNB 2904 P30

A 30 g sample of $C_6H_{11}NHPO(NH_2)_2$ from the above example was heated in a nitrogen atmosphere to 250°C for 2 hours. About 26.5 g of a dark, brittle solid was recovered in the flask. The polymeric solid was soluble in methanol.

## EXAMPLE XVIII

### Utility of the Compositions

Illustrative dopant compositions were prepared from typical selections of the above prepared triamides. The product prepared in accordance with various of the foregoing examples, as noted in Table I hereafter, are solubilized in an organic solvent such as ethanol, chloroform or toluene to a 10 to 20% wt/wt level and are dispensed onto the surface of a silicon wafer and the wafer rotated at 2,000 to 10,000 rpm to obtain thin films of the composition to be tested. The treated wafers, which may be held for up to 24 hours, are placed in a diffusion furnace and the wafer diffused under a nitrogen atmosphere at a temperature of 1000°C for 1 hour to achieve sheet resistivities of 3.9 to 13 ohms per square. The results are given in Table I below.

While in the above example no oxygen was used in the diffusion furnace, we have found the addition of up to 30% oxygen in the furnace does not adversely effect doping performance, and may improve the wafer surface condition.

TABLE I

| Compound or Polymer and Solvent (Desigrate (a), (b) or (c) | Furnace Temp °C | Atmos. 100% | Spin-on RPM | Resistivity Ohms Per Sq. | X +/- |
|---|---|---|---|---|---|
| Monomer from Ex. I | 1000 | $N_2$ | 2000 | 7.65 | 1.68 |
| Polymer from 235°C Ex. VI | 1000 | $N_2$ | 2000 | 4.17 | 0.16 |
| Polymer from 280°C Ex. VI | 1000 | $N_2$ | 2000 | 3.94 | 0.04 |
| Monomer from Ex. II | 1000 | $N_2$ | 2000 | 6.20 | 1.00 |
| Monomer from Ex. VII | 1000 | $N_2$ | 2000 | 5.50 | 0.82 |
| Polymer from Ex. XI | 1000 | $N_2$ | 2000 | 8.48 | 0.30 |
| Polymer from Ex. XII | 1000 | $N_2$ | 2000 | 8.72 | 0.47 |
| Polymer from Ex. XIII | 1000 | $N_2$ | 2000 | 8.44 | 0.22 |
| Polymer from Ex. XV | 1000 | $N_2$ | 2000 | 8.08 | 0.14 |
| Polymer from Ex. XVII | 1000 | $N_2$ | 2000 | 7.96 | 0.45 |

## INDUSTRIAL APPLICABILITY

The compositions prepared in accordance with the invention may be applied effectively as a source film for both emitter and collector diffusion applications for bipolar integrated circuits and evaluated for absolute sheet resistivities. The resulting products are characterized as having single crystal across-the-

---

a) ethanol
b) chloroform
c) tolvene

wafer and wafer-to-wafer resistivity uniformity as well as batch-to-batch resistivity uniformity, minimal wafer damage and staining, ease of processing, and compatibility with existing processes.

This product may be used on a wide range of devices for the semiconductor fabrication industry, e.g., bipolar and MOS integrated circuits, discrete devices, photovoltaic (solar) cells, and the like. Of particular applicability is usage, of the phosphoric triamide containing composition of the invention, by manufacturers of bipolar integrated circuits for emitter and collector diffusions in a typical manner.

It will be apparent that variations in the details presented herein may be made by those skilled in the art. Therefore, the invention is not to be limited except as set forth in the claims which follow.

What is claimed is:

1. A conductivity inducing film forming phosphorus dopant composition comprising at least 1.0 percent by weight in a volatile solvent of a phosphoric triamide selected from the group consisting of monomers of the formula:

$$(RNH)_3\ P:=\ X$$

and polymer thereof having the formula:

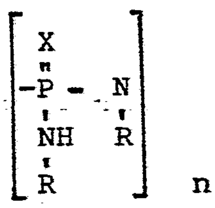

as the essential dopant ingredient, where R is selected from the group of hydrogen, aliphatic, cyclic and aromatic radicals of 1 to 12 carbon atoms and X is selected from the group consisting of oxygen and sulfur and at least one R group is always an aliphatic, cyclic or aromatic type radical.

2. The composition of claim 1 wherein the phosphoric triamide contains at least about 0.1 weight percent of cyclic compound selected from the group consisting of cyclic dimers of the formula:

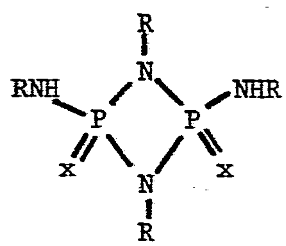

and cyclic trimers of the formula:

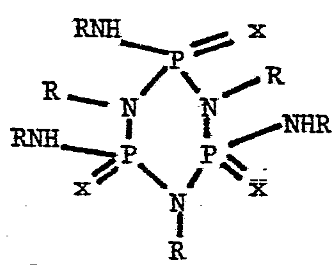

and mixtures thereof wherein R and X have the values above defined excluding, however, hydrogen.

3. The dopant composition of claim 1 wherein the

essential dopant ingredient is the monomer.

4. The dopant composition of claim 1 wherein the essential dopant component is the dimer.

5. The dopant composition of claim 1 wherein the essential dopant component is the trimer.

6. The dopant composition of claim 1 wherein the essential dopant component is the linear polymer.

7. A method of applying the polymeric composition of claim 1 to semiconductor substrates comprising dispensing the polymer in solution onto the surface of a silicon wafer, rotating the wafer at 2,000-10,000 rpm to produce a thin film of the order of 100-7000Å of the polymer on the substrate, and heating the treated wafer in a diffusion furnace for 0.1-2.0 hours at 850°C-1100°C in a nitrogen ambient (containing from 0 to 30% oxygen).

8. A method of doping semiconductor material comprising:

(a) spinning a semiconductor substrate

(b) simultaneously depositing on said substrate a solution of at least 1.0% by weight of a glassy resin derived from the dopant film forming composition of claim 1.

9. The method of claim 7 wherein said deposited solution has a resin concentration of about 1.0% to about 40% by weight.